(19)

Europäisches
Patentamt

European
Patent Office

Office européen
des brevets

(11)  EP 2 509 111 A1

(12)  EUROPEAN PATENT APPLICATION
published in accordance with Art. 153(4) EPC

(43) Date of publication:
10.10.2012  Bulletin 2012/41

(21) Application number: 09851848.3

(22) Date of filing: 02.12.2009

(51) Int Cl.:
*H01L 31/042* (2006.01)

(86) International application number:
PCT/JP2009/070242

(87) International publication number:
WO 2011/067840 (09.06.2011 Gazette 2011/23)

(84) Designated Contracting States:
AT BE BG CH CY CZ DE DK EE ES FI FR GB GR
HR HU IE IS IT LI LT LU LV MC MK MT NL NO PL
PT RO SE SI SK SM TR

(71) Applicant: Toyota Jidosha Kabushiki Kaisha
Toyota-shi, Aichi 471-8571 (JP)

(72) Inventor: INOUE Shintaro
Toyota-shi
Aichi 471-8571 (JP)

(74) Representative: Winter, Brandl, Fürniss, Hübner,
Röss, Kaiser, Polte - Partnerschaft
Alois-Steinecker-Strasse 22
85354 Freising (DE)

(54)  **SOLAR CELL MODULE MANUFACTURING DEVICE**

(57)     There is provided a solar cell module manufacturing device that includes a molding tool used to mold a solar cell module and a heating unit heating the molding tool. The solar cell module manufacturing device includes heat supply suppressing means that is provided on the molding tool and suppresses the supply of heat to the sealing member when the molding tool in which a sealing member and solar cells have been received is heated by the heating unit.

## Fig.1

## Description

### Technical Field

The present invention relates to a solar cell module manufacturing device.

### Background Art

In the past, solar cell modules have been manufactured by laminating a front plate, solar cells, a sealing member, and a reflective member on a molding tool and heating and pressing the laminated body. However, if the sealing member is melted in a manufacturing process before gas in the solar cell module is sufficiently removed, bubbles may be generated in the module. If moisture enters the bubbles, peeling of the sealing layer or corrosion or the like of the metal material of the electrode or the like occurs. Accordingly, there is proposed a solar cell module manufacturing device that includes, for example, two or more temperature control systems for heating in order to prevent the generation of bubbles (see Patent Literature 1).

### Citation List

### Patent Literature

[Patent Literature 1] Japanese Unexamined Patent Application Publication No. 11-216832

### Summary of Invention

### Technical Problem

However, even though temperature is controlled by the two or more temperature control systems for heating as in the manufacturing device disclosed in the Patent Literature 1, the supply of heat is concentrated on a partial area of the sealing member when a material having a high thermal conductivity is used for the molding tool in terms of the production speed of a solar cell module. For this reason, the sealing member is melted before gas in the solar cell module is sufficiently removed, so that bubbles may be generated in the module.

Accordingly, an object of the invention is to provide a solar cell module manufacturing device that can manufacture a good solar cell module by suppressing the concentration of the supply of heat.

### Solution to Problem

In order to achieve the above-mentioned object, the invention provides a solar cell module manufacturing device that includes a molding tool used to mold a solar cell module and a heating unit heating the molding tool. The solar cell module manufacturing device includes heat supply suppressing means that is provided on the molding tool and suppresses the supply of heat to the sealing member when the molding tool in which a sealing member and solar cells have been received is heated by the heating unit.

Since the heat supply suppressing means for suppressing the supply of heat to the sealing member is provided on the molding tool, it is possible to prevent bubbles from being generated in the module by suppressing the concentration of the supply of heat on a partial area of the sealing member when the molding tool in which the sealing member and the solar cells have been received is heated by the heating unit. Therefore, it is possible to manufacture a good solar cell module.

In the invention, the heat supply suppressing means may be disposed in the vicinity of a heat oversupply area of the sealing member where surfaces of the molding tool are close to each other. Since the heat supply suppressing means is disposed in the vicinity of the heat oversupply area of the sealing member where the surfaces of the molding tool are close to each other, it is possible to suppress the concentration of the supply of heat on the heat oversupply area of the sealing member.

In the invention, an inner surface of a bottom portion of the molding tool may have a concavo-convex shape. If the inner surface of the bottom portion of the molding tool has a concavo-convex shape, the surfaces are close to each other, so that the supply of heat becomes excessive. However, it is possible to suppress the concentration of the supply of heat on the heat oversupply area of the sealing member by the heat supply suppressing means.

Further, in the invention, the heat supply suppressing means may be a heat resistant plate that is provided on an inner surface of the molding tool and hinders the transfer of heat to the heat oversupply area. Since the heat resistant plate, which hinders the transfer of heat to the heat oversupply area, is provided on the inner surface of the molding tool, it is possible to further suppress the concentration of the supply of heat to the heat oversupply area of the sealing member.

In the invention, when the coefficient of thermal conductivity, the specific heat, and the density of a portion of the molding tool on which the heat resistant plate is not provided are denoted by $\lambda_1$, $c_1$, and $\rho_1$, and the coefficient of thermal conductivity, the specific heat, and the density of the heat resistant plate are denoted by $\lambda_2$, $c_2$, and $\rho_2$, the heat supply suppressing means may be set so that the following expression (1) is satisfied.

[Expression 1]

$$\frac{\lambda_1}{\rho_1 c_1} > \frac{\lambda_2}{\rho_2 c_2} \quad \dots (1)$$

If the heat supply suppressing means is set so that the expression (1) is satisfied, it is possible to further suppress the concentration of the supply of heat on the heat oversupply area of the sealing member since the thermal conductivity of the heat resistant plate is lower than the thermal conductivity of a portion of the molding tool on which the heat resistant plate is not provided.

Furthermore, in the invention, the heat supply suppressing means may be disposed between a side wall portion and the bottom portion of the molding tool. Since the heat supply suppressing means is disposed between the side wall portion and the bottom portion of the molding tool, the side wall portion and the bottom portion do not come into contact with each other and heat from the heating unit is hardly transferred to the side wall portion from the bottom portion. Accordingly, it is possible to further suppress the concentration of the supply of heat on the heat oversupply area of the sealing member.

In the invention, the heat supply suppressing means may be heat dissipating fins disposed at the side wall portion. Since the heat dissipating fins are disposed at the side wall portion, it is possible to further suppress the concentration of the supply of heat on the heat oversupply area of the sealing member.

Moreover, in the invention, the heat supply suppressing means may be a heat dissipating member that is mounted on an outer surface of the side wall portion and discharges heat to an outer surface of the molding tool. Since the heat dissipating member is mounted on the outer surface of the side wall portion, it is possible to further suppress the concentration of the supply of heat on the heat oversupply area of the sealing member.

**Advantageous Effects of Invention**

According to the invention, it is possible to provide a solar cell module manufacturing device that can manufacture a good solar cell module by suppressing the concentration of the supply of heat.

**Brief Description of Drawings**

Fig. 1 is a cross-sectional view showing the structure of a solar cell module manufacturing device 10a according to a first embodiment of the invention.

Figs. 2A and 2B are conceptual diagrams of models illustrating Expression (1).
Fig. 3 is a cross-sectional view showing the structure of a solar cell module manufacturing device 10b according to a modification of the first embodiment of the invention.
Figs. 4A and 4B are conceptual diagrams of models illustrating Expression (3).
Fig. 5 is a graph showing a relationship between the melting point of a sealing member and the center temperature and the end portion temperature of a module.
Figs. 6A and 6B are cross-sectional views of a molding tool of the solar cell module manufacturing device according to this embodiment.
Fig. 7 is a cross-sectional view of a molding tool of a solar cell module manufacturing device according to a second embodiment of the invention.
Fig. 8 is a cross-sectional view of the molding tool of the solar cell module manufacturing device according to the second embodiment of the invention.
Fig. 9A is a partial cross-sectional view of a solar cell module and Fig. 9B is a cross-sectional view of the molding tool.
Fig. 10 shows a molding tool 5 that is used to mold the solar cell module of Fig. 9A.
Fig. 11A is a partial cross-sectional view of a solar cell module where a reflective member is integrally molded and Fig. 11B is a cross-sectional view of a molding tool.

Figs. 12A to 12C are cross-sectional views of the respective molding tools that are used to mold solar cell modules.

Fig. 13 is a cross-sectional view of a molding tool that is used to mold a solar cell module.

Figs. 14A and 14B are views showing the appearance and the cross-sectional shape of a molding tool that is used in this experiment.

Fig. 15 is a partial cross-sectional view showing a sealing member and the like that are laminated on the molding tool used in this experiment.

**Description of Embodiments**

Embodiments of the invention will be described below. Meanwhile, the same elements shown in the drawings are denoted by the same reference numerals, and repeated description will be omitted. Further, the dimensional ratios in the drawings do not necessarily correspond to objects to be described.

(First embodiment)

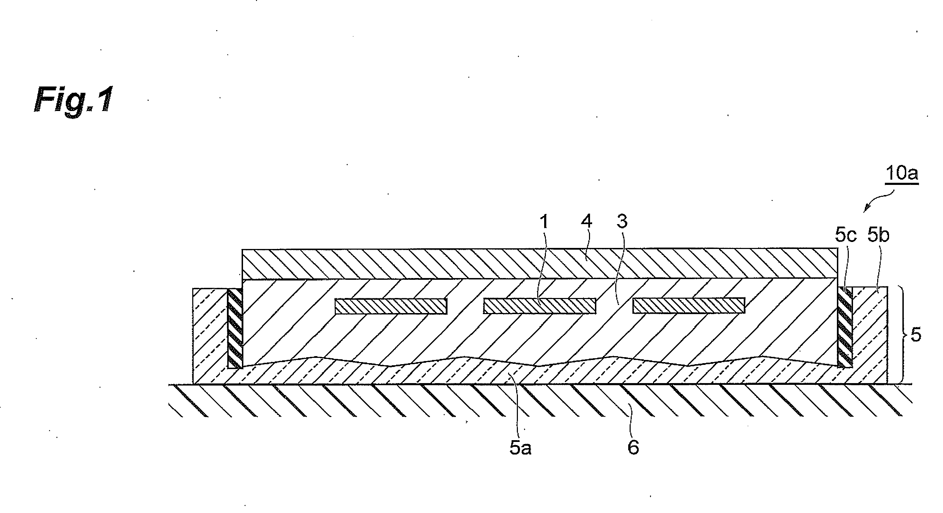

Fig. 1 is a cross-sectional view showing the structure of a solar cell module manufacturing device 10a according to a first embodiment of the invention. The solar cell module manufacturing device 10a includes a molding tool 5 and a heating unit 6. Solar cells 1 and a sealing member 3 are received in the molding tool 5, and a front plate 4 is disposed on the sealing member 3.

The molding tool 5 includes a bottom portion 5a and side wall portions 5b that are formed at both end portions of the bottom portion 5a, and has a structure where the sealing member 3 is received on the inside of the inner surfaces of the bottom portion 5a and the side wall portions 5b, that is, within the bottom portion 5a and the side wall portions 5b. The surface of the bottom portion 5a has a shape corresponding to the shape of a solar cell module 10a, and has a shape corresponding to the concavo-convex shape of the back surface of a reflective member, which is to be mounted in a post-process, in Fig. 1.

As long as the molding tool 5 is made of a material having excellent thermal conductivity, the material of the molding tool is not particularly limited. For example, aluminum (A5052) or the like may be used as the material of molding tool.

As long as the molding tool 5 can be placed on the heating unit 6 and the heating unit 6 can heat the molding tool up to a predetermined temperature, any member may be used as the heating unit 6. Examples of the heating unit 6 include a flat heat plate.

The solar cell 1 is a double-side incidence type solar cell element that can receive light on both the surface and back surface thereof, and is made of single-crystalline silicon, polycrystalline silicon, amorphous silicon, or the like. The solar cells 1 are sealed by the sealing member 3 so that a plurality of solar cells are regularly disposed and electrically connected in the module.

The sealing member 3 seals a gap between the front plate 4 and a reflective member 2a, and it is preferable that the sealing member contain an ethylene-vinyl acetate copolymer (EVA). The sealing member 3 stabilizes and fixes the positions of the solar cells 1 by sealing the gap between the front plate 3 and the reflective member 2a.

The sealing member 3 and the solar cells 1 are received in the molding tool 5 as described above and the molding tool 5 is placed on the heating unit 6 and heated, so that heat is transferred to the sealing member 3 received in the molding tool 5 and the sealing member 3 is melted. Accordingly, the sealing member 3 is molded in a predetermined shape in the molding tool 5.

In the solar cell module manufacturing device 10a, heat resistant plates 5c are provided on the inner surfaces (the surfaces that come into contact with the sealing member 3 received in the molding tool 5) of the side wall portions 5b as heat supply suppressing means.

The heat supply suppressing means suppresses the supply of heat in order to prevent heat from being concentrated on a partial area of the sealing member 3 when heat from the heating unit 6 is transferred to the sealing member 3 through the molding tool 5. For example, the heat supply suppressing means may have thermal conductivity lower than the thermal conductivity of the molding tool so as to hinder the transfer of heat to the sealing member 3 close to the inner surfaces of the molding tool 5, and examples of the heat supply suppressing means include a heat resistant plate, a liquid such as oil, and a gas such as air. Further, the heat supply suppressing means may discharge heat to the outer surfaces of the molding tool, and examples of the heat supply suppressing means include heat dissipating fins and heat dissipating members having a high heat capacity.

Here, the partial area of the sealing member 3 means areas (hereinafter, referred to as "heat oversupply areas") to which heat is over-supplied since the surfaces of the molding tool are close to each other. The surfaces of the molding tool may be, for example, the inner surface of the bottom portion 5a and the inner surfaces of the side wall portions 5b, or inclined surfaces that form the concave shape of the concavo-convex shape of the inner surface of the bottom portion 5a. The angle of a bent portion, which is formed since the surfaces are close to each other, facing the sealing member 3 is smaller than 180°C. Accordingly, heat from both the surfaces is transferred inward, so that the concentration of the supply of heat occurs.

The vicinity of the heat oversupply areas of the sealing member 3 is the vicinity of portions where the surfaces of the molding tool forming the heat oversupply areas are close to each other, and may be, for example, the inner surface of the bottom portion 5a, the inner surfaces of the side wall portions 5b, or the inner surfaces of the inclined surfaces that form the concave shape of the concavo-convex shape of the inner surface of the bottom portion 5a.

Since the heat resistant plates 5c are provided in the vicinity of the heat oversupply areas of the sealing member 3 as the heat supply suppressing means, it is possible to suppress the supply of heat to the heat oversupply areas where the inner surface of the bottom portion 5a and the inner surfaces of the side wall portions 5b are close to each other. As a result, it is possible to prevent bubbles from being generated in the module, so that it is possible to manufacture a good solar cell module.

As long as the thermal conductivity of the material of the heat resistant plate, which is the heat supply suppressing means, is lower than the thermal conductivity of the material of the molding tool, the material of the heat resistant plate is not particularly limited. For example, polytetrafluoroethylene (PTFE) or the like may be used as the material of the heat resistant plate.

When the coefficient of thermal conductivity, the specific heat, and the density of the bottom portion 5a and the side wall portions 5b, which are portions of the molding tool on which the heat resistant plate is not provided, are denoted by $\lambda_1$, $c_1$, and $\rho_1$, and the coefficient of thermal conductivity, the specific heat, and the density of the heat resistant plate 5c are denoted by $\lambda_2$, $c_2$, and $\rho_2$, it is preferable that the thermal conductivity of the above-mentioned heat supply suppressing means be set so that the following expression (1) is satisfied.

[Expression 1]

$$\frac{\lambda_1}{\rho_1 c_1} > \frac{\lambda_2}{\rho_2 c_2} \quad \dots (1)$$

If the heat supply suppressing means is set so that Expression (1) is satisfied, the thermal conductivity of the heat resistant plate is lower than the thermal conductivity of the portions of the molding tool on which the heat resistant plate is not provided. Accordingly, it is possible to further suppress the concentration of the supply of heat on the heat oversupply areas of the sealing member.

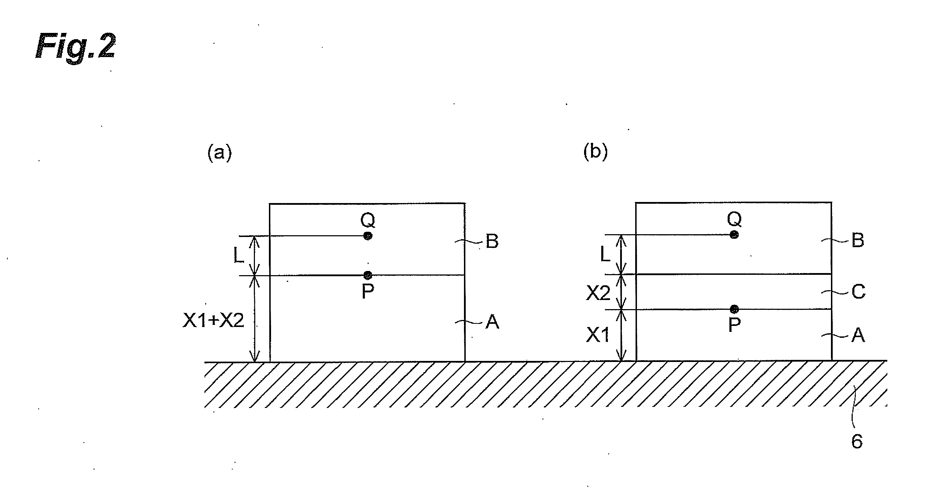

Figs. 2A and 2B are conceptual diagrams of models illustrating Expression (1). Fig. 2A shows a case where a heat resistant plate C is not provided, and Fig. 2B shows a case where a heat resistant plate C is provided. Since a portion (for example, the bottom portion 5a) A of the molding tool on which the heat resistant plate is not provided has high thermal conductivity, the temperature of a point P is hardly affected by a distance $(x_1+x_2)$ from the heating unit 6 and reaches high temperature. Accordingly, in order to suppress the amount of heat supplied to a point Q of a sealing member B, it is necessary to make the thermal conductivity of the heat resistant plate C be lower than the thermal conductivity of the portion (for example, the bottom portion 5a) A of the molding tool on which the heat resistant plate is not provided. Further, a primary heat transfer fundamental expression can be represented by Expression (2).

[Expression 2]

$$\frac{\delta T}{\delta t} > \frac{\lambda}{\rho c} \frac{\delta^2 T}{\delta x^2} \quad \dots (2)$$

From Expression (2), it is understood that it is effective to make the ratio $\lambda/\rho c$ (thermal conductivity), which is a material property, small and to make the heat transfer distance x small in order to suppress thermal conductivity. From the above description, it is possible to derive Expression (1).

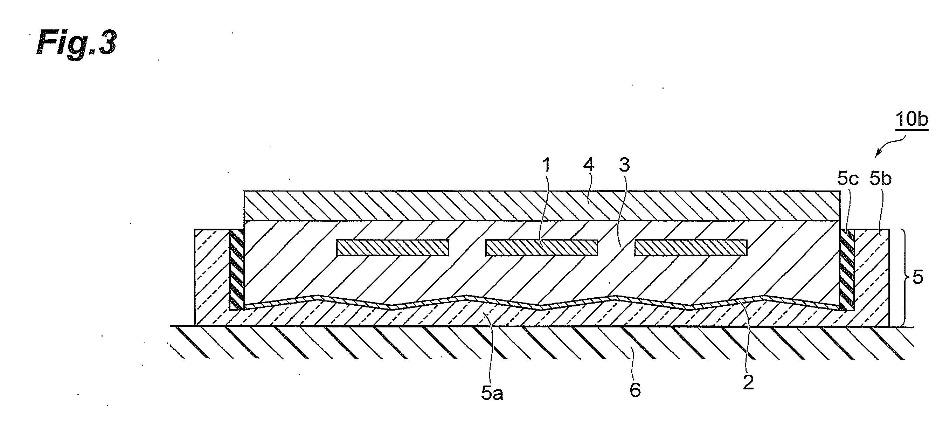

Fig. 3 is a cross-sectional view showing the structure of a solar cell module manufacturing device 10b according to a modification of the first embodiment of the invention. The solar cell module manufacturing device 10b includes a molding tool 5 and a heating unit 6. Solar cells 1, a reflective member 2, and a sealing member 3 are received in the molding tool 5, and a front plate 4 is disposed on the sealing member 3. Further, the molding tool 5 includes a bottom portion 5a, side wall portions 5b, and heat resistant plates 5c (heat supply suppressing means) that are provided on the inner surfaces of the side wall portions 5b. In comparison with the solar cell module manufacturing device 10a, the solar cell module manufacturing device 10b is characterized in that the reflective member 2 is also simultaneously molded as a module.

The vicinity of heat oversupply areas of the sealing member 3 is the vicinity of portions where the surfaces of the molding tool forming the heat oversupply areas are close to each other when the reflective member 2 is also simultaneously molded as a module as in the solar cell module manufacturing device 10b, and may be, for example, the inner surfaces of the side wall portions 5b, the inner surface of the bottom portion 5a, or the inner surfaces of the inclined surfaces (the back surface of the reflective member) that form the concave shape of the concavo-convex shape of the inner surface of the bottom portion 5a.

When the coefficient of thermal conductivity, the specific heat, the density, and the thickness of the reflective member 2 are denoted by $\lambda_3$, $c_3$, $\rho_3$, and $x_3$ and the coefficient of thermal conductivity, the specific heat, the density, and the thickness of the heat resistant plate 5c are denoted by $\lambda_2$, $c_2$, $\rho_2$, and $x_2$, it is preferable that the thermal conductivity of the above-mentioned heat resistant plate 5c be set so that the following expression (3) is satisfied.

[Expression 3]

$$\frac{\lambda_3}{\rho_3 c_3 (x_3)^2} > \frac{\lambda_2}{\rho_2 c_2 (x_2)^2} \quad \ldots (3)$$

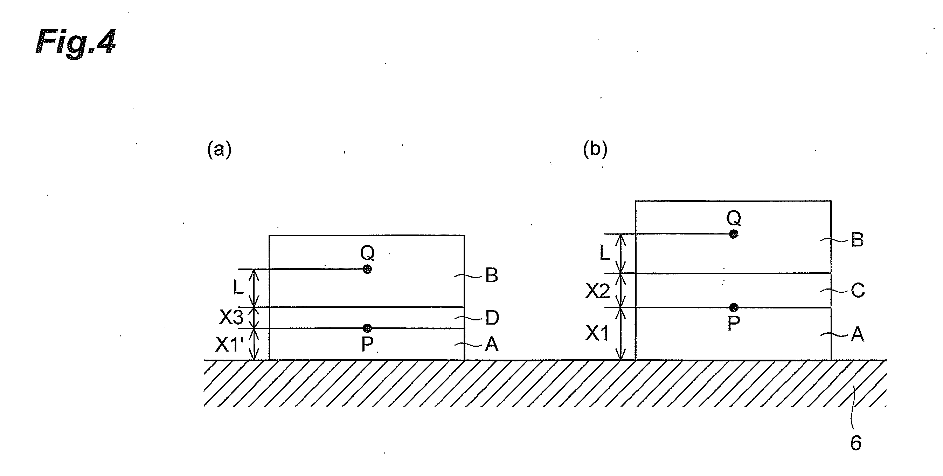

Figs. 4A and 4B are conceptual diagrams of models illustrating Expression (3). Fig. 4A shows a case where a reflective member D is interposed between a sealing member B and a portion (for example, the bottom portion 5a) A of the molding tool where the heat resistant plate is not provided, and Fig. 4B shows a case where a heat resistant plate C is interposed between a sealing member B and a portion (for example, the bottom portion 5a) A of the molding tool where the heat resistant plate is not provided. Since the temperature of a point P is substantially the same, it is necessary to make the thermal conductivity of the heat resistant plate C be lower than the thermal conductivity of the reflective member D in order to suppress the amount of heat supplied to a point Q of the sealing member B. Due to the difference in thickness, it is preferable that the thermal conductivity of the above-mentioned heat resistant plate C be set so that Expression (3) considering thickness is satisfied.

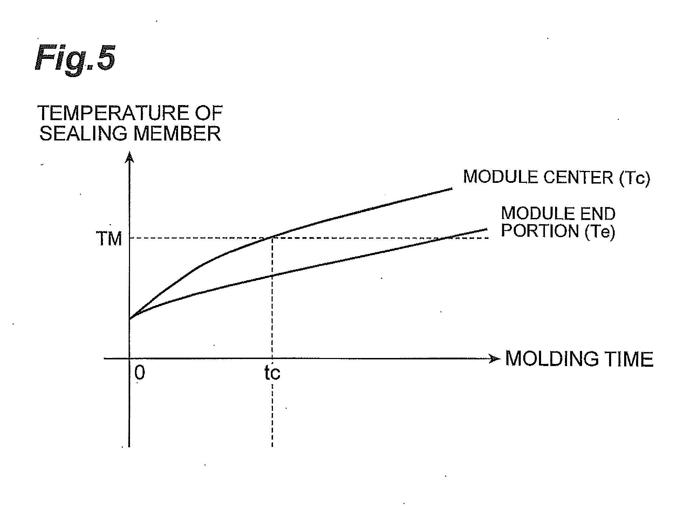

Fig. 5 is a graph showing a relationship between the melting point of the sealing member and the center temperature Tc and the end portion temperature Te of a module. Since the heat resistant plates 5c are provided on the back surfaces of the inner surfaces of the side wall portions 5b in the solar cell module manufacturing device 10a according to this embodiment, the end portion temperature Te of the sealing member hardly rises and Expression (4) is satisfied in the time range of 0 to tc as shown in Fig. 5 when a time where Tc is equal to TM is represented by tc.

$$Te < Tc \ldots (4)$$

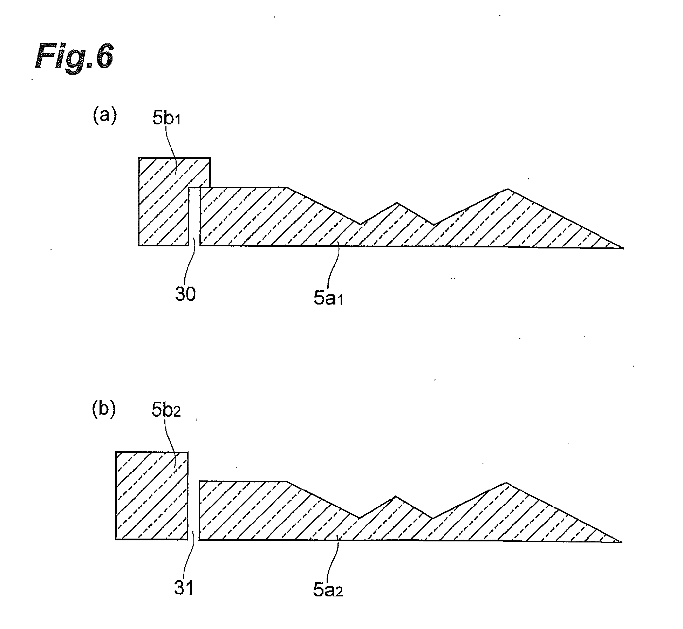

Figs. 6A and 6B are cross-sectional views of the molding tool of the solar cell module manufacturing device according to this embodiment. It is also preferable that the molding tool have a structure where a gap portion 30 is formed between a bottom portion $5a_1$ and a side wall portion $5b_1$ as heat supply suppressing means as shown in Fig. 6A so that the area of portions coming into contact with each other is reduced. Accordingly, it is possible to suppress the amount of heat supplied to the end portion of the sealing member.

Further, it is also preferable that the molding tool have a structure where a space portion 31 is formed between a bottom portion $5a_2$ and a side wall portion $5b_2$ as heat supply suppressing means as shown in Fig. 6B so that the bottom portion $5a_2$ and the side wall portion $5b_2$ are separated from each other and do not come into contact with each other. Accordingly, it is possible to further suppress the amount of heat supplied to the end portion of the sealing member. Meanwhile, if the sealing member is melted due to heat when the bottom portion $5a_2$ and the side wall portion $5b_2$ of the molding tool are separated from each other as shown in Fig. 6B, the melted sealing member flows into the space portion 31, so that the inside of the module cannot be sealed. Accordingly, it is necessary to close up at least a part of the space portion 31 with, for example, a heat resistant plate or the like.

As described above, according to the solar cell module manufacturing devices 10a and 10b of the first embodiment, the concentration of the supply of heat on the sealing member is suppressed, so that it is possible to prevent bubbles from being generated in the module. Accordingly, it is possible to manufacture a good solar cell module.

(Second embodiment)

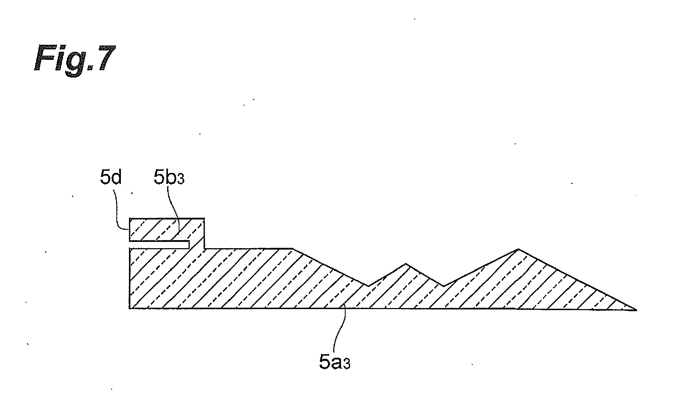

Fig. 7 is a cross-sectional view of a molding tool of a solar cell module manufacturing device according to a second embodiment. It is preferable that heat dissipating fins 5d be disposed at a side wall portion $5b_3$ as shown in Fig. 7. Accordingly, it is possible to dissipate heat, which is transferred to the sealing member from the side wall portion $5b_3$, to the outer surface of the molding tool 5 and to suppress the amount of heat supplied to heat oversupply areas of the sealing member corresponding to the inner surface.

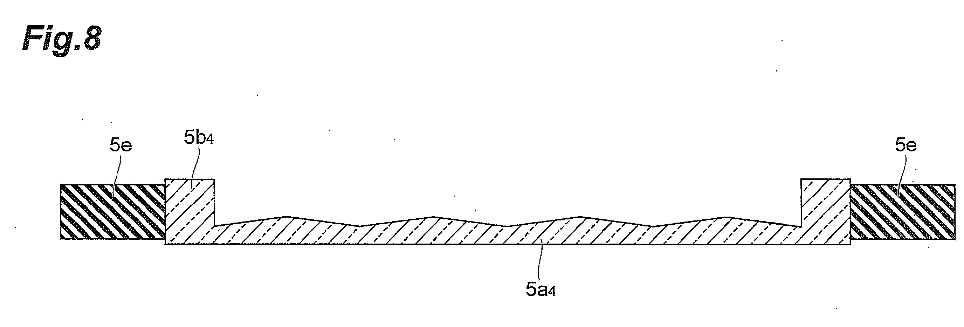

Fig. 8 is a cross-sectional view of the molding tool of the solar cell module manufacturing device according to the second embodiment. It is preferable that heat dissipating members 5e be mounted on the outer surfaces of side wall portions $5b_4$ as shown in Fig. 8. It is possible to discharge heat, which is to be supplied, to the outer surface of the molding tool 5 by mounting the heat dissipating members 5e, which have a high heat capacity, on the outer surfaces of the side wall portions $5b_4$ as described above. Accordingly, it is possible to further suppress the amount of heat supplied to the heat oversupply areas of the sealing member corresponding to the inner surface.

A case where the heat supply suppressing means are mainly provided on the side wall portions of the molding tool has been described in the above-mentioned respective embodiments. However, the heat supply suppressing means may be applied to concave portions of the inner surface of the bottom portion having a concavo-convex shape. For example, if the heat resistant plates 5c are applied to the concave portions of the inner surface of the bottom portion 5a of the molding tool 5 in Fig. 1, it is possible to suppress the concentration of the supply of heat on the heat oversupply areas of the sealing member 3.

(Example 1)

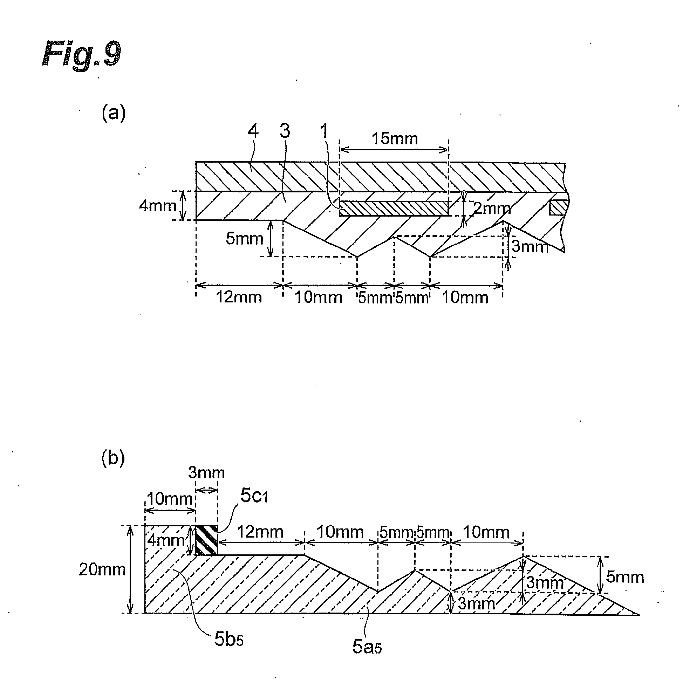

Fig. 9A is a partial cross-sectional view of a solar cell module and Fig. 9B is a cross-sectional view of the molding tool. The solar cell module is formed so as to have the dimensions and shape shown in Fig. 9A, and the solar cell 1 is a double-side light receiving cell having a width of 15 mm. The distance between a front plate 4 and the solar cell is 2 mm. The sealing member 3 is EVA (manufactured by Bridgestone Corporation), and the front plate 4 is a heat-treated white plate glass (manufactured by AGC) having a thickness of 3.2 mm.

Fig. 9B shows the molding tool 5 that is used to mold the solar cell module of Fig. 9A, and the molding tool is formed so as to have the dimensions and shape corresponding to the solar cell module of Fig. 9A. A bottom portion $5a_5$ and a side wall portion $5b_5$ of the molding tool 5 are made of aluminum (A5052), and a heat resistant plate $5c_1$ is made of PTFE. Thermophysical properties of each of the bottom portion and the side wall portion are shown in Table 1.

[Table 1]

| Material | Coefficient of thermal conductivity [W/m·K] | Specific heat [J/kg·K] | Density [kg/m$^3$] |
|---|---|---|---|
| Aluminum (A5052) | 140 | 900 | 2700 |
| PTFE | 0.24 | 1000 | 2200 |

Thermophysical properties of each of the bottom portion $5a_5$ and the side wall portion $5b_5$ of the molding tool 5 and the heat resistant plate $5c_1$, which are shown in Table 1, satisfy the above-mentioned Expression (1). Accordingly, it is possible to suppress the amount of heat supplied to the end portions of the sealing member 3 that are the heat oversupply areas. As a result, it is possible to manufacture a good solar cell module that prevents bubbles from being generated in the module.

(Example 2)

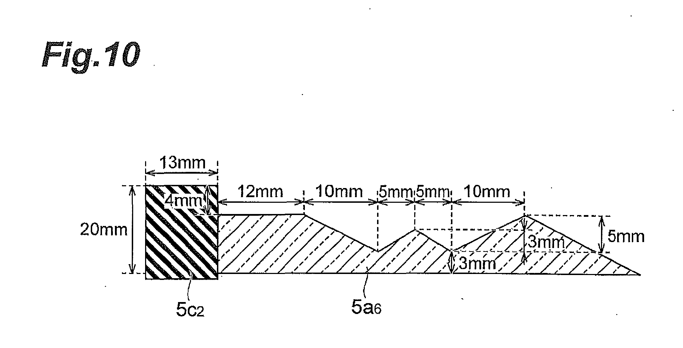

Fig. 10 is a cross-sectional view of the molding tool 5 that is used to mold the solar cell module of Fig. 9A, and the molding tool is formed so as to have the dimensions and shape corresponding to the solar cell module of Fig. 9A as shown in Fig. 10. A bottom portion $5a_6$ of the molding tool 5 is made of aluminum (A5052), and a heat resistant plate $5c_2$ is made of PTFE. However, since the heat resistant plate $5c_2$ also functions as a side wall portion, it is possible to suppress the amount of heat supplied to the end portions of the sealing member 3, which are the heat oversupply areas, even in this form. Accordingly, it is possible to manufacture a good solar cell module that prevents bubbles from being generated in the module.

(Example 3)

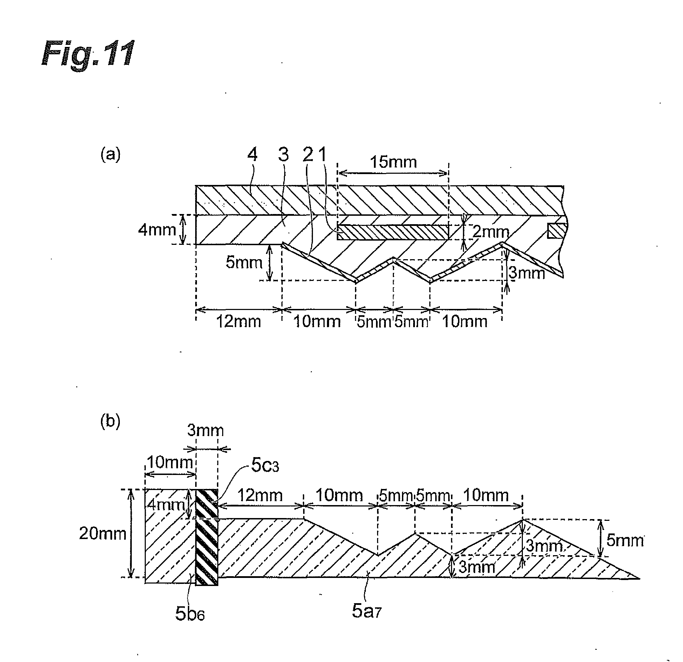

Fig. 11A is a partial cross-sectional view of a solar cell module where a reflective member 2 is integrally molded, and the solar cell module is formed so as to have the dimensions and shape shown in Fig. 11A. A solar cell 1 is a double-side light receiving cell having a width of 15 mm. The distance between a front plate 4 and the solar cell is 2 mm. A sealing member 3 is EVA (manufactured by Bridgestone Corporation), and the front plate 4 is a heat-treated white plate glass (manufactured by AGC) having a thickness of 3.2 mm. The reflective plate 2 is made of SUS304 and has a thickness of 0.5 mm.

Fig. 11B is a cross-sectional view of the molding tool that is used to mold the solar cell module of Fig. 11A, and the molding tool is formed so as to have the dimensions and shape corresponding to the solar cell module of Fig. 11A. A bottom portion $5a_7$ of the molding tool 5 is made of aluminum (A5052), and a heat resistant plate $5c_3$ is made of PTFE. The heat resistant plate $5c_3$ is disposed so as to isolate the bottom portion $5a_7$ of the molding tool 5 from a side wall portion $5b_6$. Thermophysical properties of each of the reflective plate 2 and the heat resistant plate $5c_3$ are shown in Table 2.

[Table 2]

| Material | Coefficient of thermal conductivity [W/m·K] | Specific heat [J/kg·K] | Density [kg/m$^3$] | Thickness [mm] |
|---|---|---|---|---|
| SUS304 | 17 | 590 | 7930 | 0.5 |
| PTFE | 0.24 | 1000 | 2200 | 3 |

As shown in Table 2, thermophysical properties of each of the reflective plate 2 and the heat resistant plate $5c_3$ satisfy the above-mentioned Expression (3). Accordingly, it is possible to further suppress the amount of heat supplied to the end portions of the sealing member 3 that are the heat oversupply areas. As a result, it is possible to manufacture a good solar cell module that prevents bubbles from being generated in the module.

(Example 4)

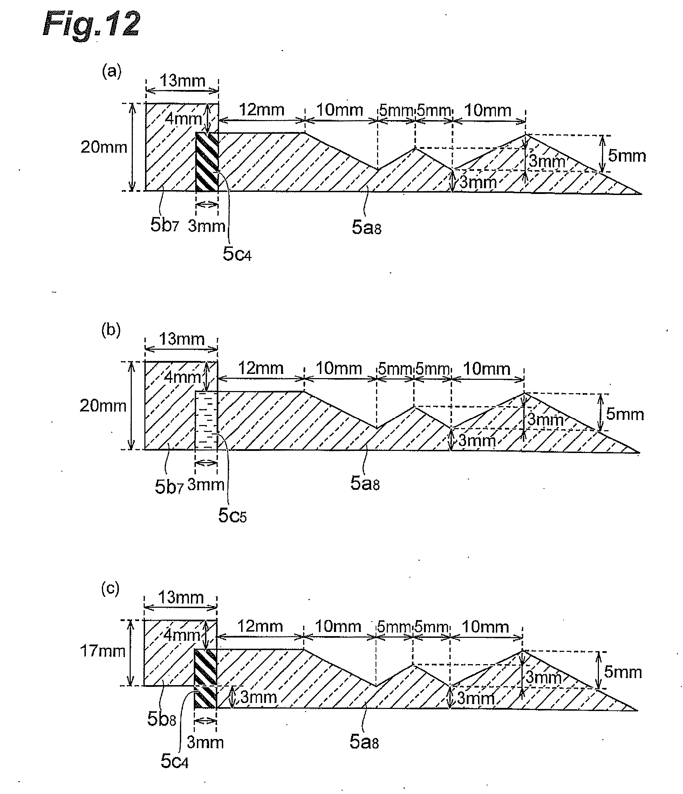

Figs. 12A to 12C are cross-sectional views of the respective molding tools that are used to mold solar cell modules, and the molding tools are formed so as to have the dimensions and shapes shown in Figs. 12A to 12C. Here, a bottom portion $5a_8$ of a molding tool 5 of Fig. 12A is made of aluminum (A5052), and a heat resistant plate $5c_4$ is made of PTFE. However, since the heat resistant plate $5c_4$ is provided on the side portion of the bottom portion $5a_8$, the heat resistant plate does not come into direct contact with the sealing member of the solar cell module. Even in this structure, heat from the bottom portion $5a_8$ is hardly transferred to a side wall portion $5b_7$. Accordingly, the amount of heat supplied to the end portion of the sealing member, which is the heat oversupply area, is further suppressed. As a result, it is possible to manufacture a good solar cell module that prevents bubbles from being generated in the module.

(Example 5)

Further, the dimensions and shape of a molding tool 5 of Fig. 12B are the same as those of the molding tool 5 of Fig. 12A, but the molding tool 5 of Fig. 12B is different from the molding tool 5 of Fig. 12A in that heat supply suppressing means is oil $5c_5$. Even though the heat supply suppressing means is liquid as described above, heat from the bottom portion $5a_8$ is hardly transferred to the side wall portion $5b_7$. Accordingly, it is possible to further suppress the amount of heat supplied to the end portion of the sealing member that is the heat oversupply area. As a result, it is possible to manufacture a good solar cell module that prevents bubbles from being generated in the module.

(Example 6)

Furthermore, the dimensions and shapes of a bottom portion $5a_8$ and a heat resistant plate $5c_4$ of a molding tool 5 of Fig. 12C are the same as those of the molding tool 5 of Fig. 12A, but the molding tool 5 of Fig. 12C is different from the molding tool 5 of Fig. 12A in that the lower portion of the side wall portion $5b_8$ does not come into contact with a heating unit 6. In this structure, heat is hardly transferred to the side wall portion $5b_8$. Accordingly, the amount of heat supplied to the end portion of the sealing member, which is the heat oversupply area, is further suppressed. As a result, it is possible to manufacture a good solar cell module that prevents bubbles from being generated in the module.

(Example 7)

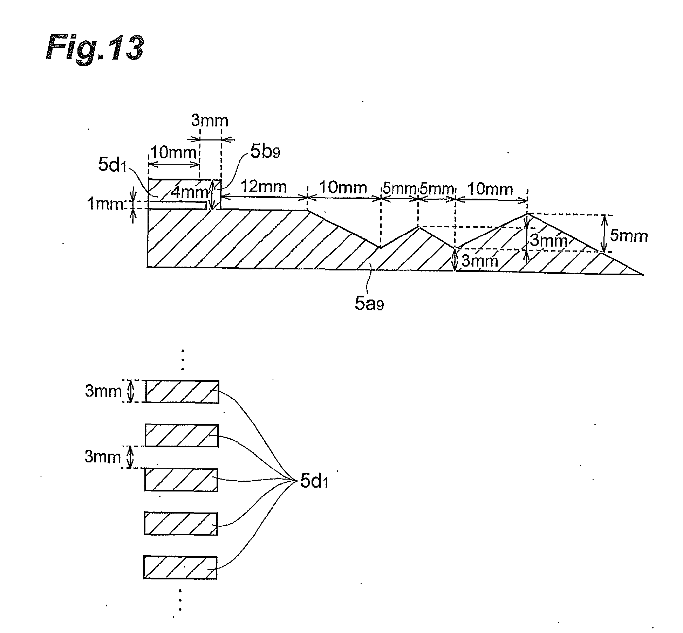

Fig. 13 is a cross-sectional view of a molding tool 5 that is used to mold a solar cell module. The molding tool is formed so as to have the dimensions and shape shown in Fig. 13, but a side wall portion $5b_9$ includes heat dissipating fins $5d_1$. Since a part of the side wall portion $5b_9$ includes heat dissipating fins $5d_1$ as described above, heat transferred to the sealing member from the side wall portion $5b_9$ is dissipated to the outer surface of the molding tool 5. Accordingly, the amount of heat supplied to the end portion of the sealing member, which is the heat oversupply area, is further suppressed. As a result, it is possible to manufacture a good solar cell module that prevents bubbles from being generated in the module.

(Reference example)

In the invention, the fact that it is necessary to use a material having a high thermal conductivity for the bottom portion of a molding tool in terms of productivity is shown as a reference example by the results of the following experiment.

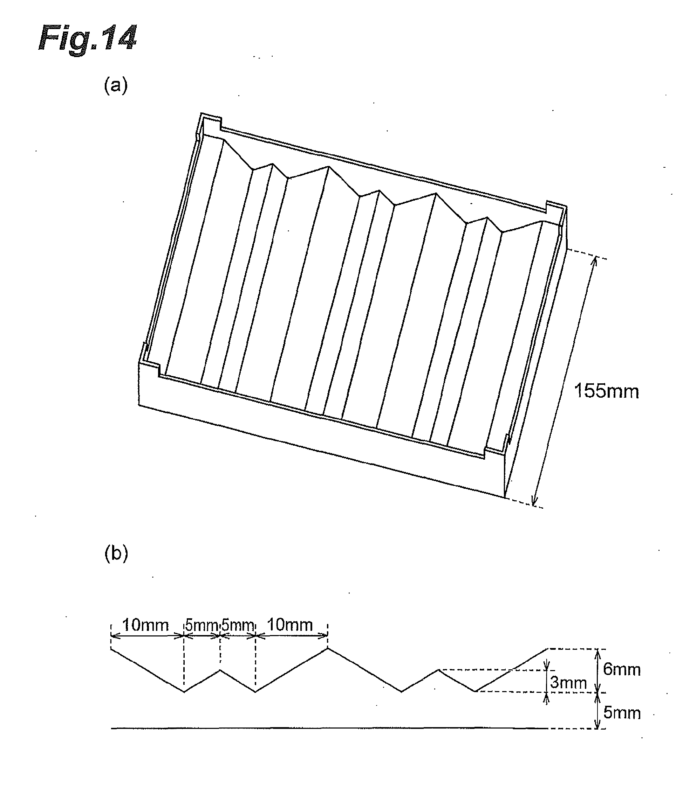

Figs. 14A and 14B are views showing the appearance and the cross-sectional shape of a molding tool that is used in this experiment. Fig. 14A shows the shape of the molding tool used in this experiment, and three W-shaped convexo-concave portions are formed. A molding tool made of aluminum (A5052) and a molding tool made of PTFE, that is, two molding tools, which have the same shape but are made of different materials, were used in this experiment. Further, as shown in Fig. 14B, the cross-sectional shape of the molding tool is formed so that the thickness of the molding tool at the end portions of a W shape is 11 mm and the thickness of the molding tool at the middle portion of the W shape is 8 mm, and the thickness of the molding tool at the thinnest portion is 5 mm.

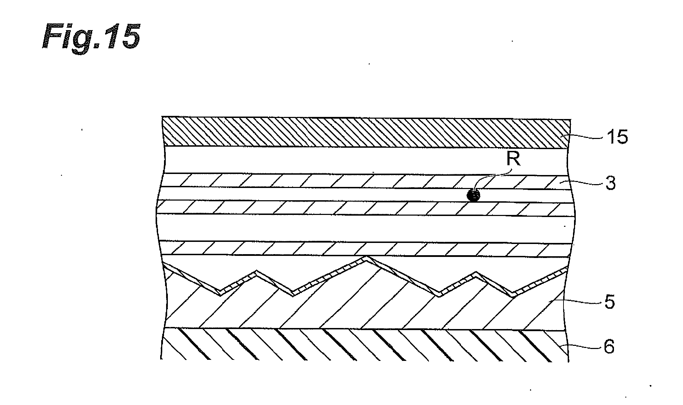

Fig. 15 is a partial cross-sectional view showing a sealing member and the like that are laminated on the molding tool used in this experiment. In this experiment, nine EVA sheets, which are sealing parts, were laminated on a molding tool at room temperature first, a thermocouple was interposed between the eighth and ninth EVA sheets from below, and the molding tool was then placed on a heat plate of which the temperature was set to 165°C. The temperature of the measurement point and time until the EVA sheet reaches 70°C where the EVA sheets melted were measured under vacuum (30 Pa). Results are shown in Table 3.

[Table 3]

| Material | Time until temperature reaches 70°C (Min.) |
|---|---|
| Aluminum (A5052) | 77 |
| PTFE | 140 |

As shown in Table 3, 140 minutes was taken until the EVA sheet reaches 70°C in the case of the molding tool made of PTFE that is a material having a low thermal conductivity, but 77 minutes was taken until the EVA sheet reaches 70°C in the case of the molding tool made of aluminum. Since the production speed of a general solar cell is about 60 minutes per module, it is preferable that a material having a high thermal conductivity such as aluminum be used for the molding tool in terms of productivity.

**Industrial Applicability**

According to the invention, it is possible to provide a solar cell module manufacturing device that can manufacture a good solar cell module by suppressing the concentration of the supply of heat.

**Reference Signs List**

1: solar cell
2: reflective member
3: sealing member
5: molding tool
5a: bottom portion
5b: side wall portion
5c: heat resistant plate (heat supply suppressing means)

5d:     heat dissipating fin
5e:     heat dissipating member
6:      heating unit
10:     solar cell module manufacturing device

**Claims**

1.  A solar cell module manufacturing device that includes a molding tool used to mold a solar cell module and a heating unit heating the molding tool, the solar cell module manufacturing device comprising:

    heat supply suppressing means that is provided on the molding tool and suppresses the supply of heat to the sealing member when the molding tool in which a sealing member and solar cells have been received is heated by the heating unit.

2.  The solar cell module manufacturing device according to claim 1,
    wherein the heat supply suppressing means is disposed in the vicinity of a heat oversupply area of the sealing member where surfaces of the molding tool are close to each other.

3.  The solar cell module manufacturing device according to claim 1 or 2,
    wherein an inner surface of a bottom portion of the molding tool has a concavo-convex shape.

4.  The solar cell module manufacturing device according to any one of claims 1 to 3,
    wherein the heat supply suppressing means is a heat resistant plate that is provided on an inner surface of the molding tool and hinders the transfer of heat to the heat oversupply area.

5.  The solar cell module manufacturing device according to any one of claims 1 to 4,
    wherein when the coefficient of thermal conductivity, the specific heat, and the density of a portion of the molding tool on which the heat resistant plate is not provided are denoted by $\lambda_1$, $c_1$, and $\rho_1$, and the coefficient of thermal conductivity, the specific heat, and the density of the heat resistant plate are denoted by $\lambda_2$, $c_2$, and $\rho_2$, the heat supply suppressing means is set so that the following expression (1) is satisfied.

[Expression 1]

$$\frac{\lambda_1}{\rho_1 c_1} > \frac{\lambda_2}{\rho_2 c_2} \quad \dots (1)$$

6.  The solar cell module manufacturing device according to any one of claims 1 to 5,
    wherein the heat supply suppressing means is disposed between a side wall portion and the bottom portion of the molding tool.

7.  The solar cell module manufacturing device according to any one of claims 1 to 6,
    wherein the heat supply suppressing means is heat dissipating fins disposed at the side wall portion.

8.  The solar cell module manufacturing device according to any one of claims 1 to 7,
    wherein the heat supply suppressing means is a heat dissipating member that is mounted on an outer surface of the side wall portion and discharges heat to an outer surface of the molding tool.

*Fig.1*

**Fig.2**

(a)

(b)

EP 2 509 111 A1

**Fig.3**

*Fig.4*

(a)

(b)

EP 2 509 111 A1

## Fig.5

TEMPERATURE OF
SEALING MEMBER

# Fig.6

(a)

5b₁

30

5a₁

(b)

5b₂

31

5a₂

# Fig.7

5d    5b3

5a3

Fig.8

# Fig.9

(a)

(b)

*Fig.10*

13mm

4mm

20mm

12mm    10mm    5mm 5mm    10mm

5mm

3mm

3mm

5c2                5a6

# *Fig.11*

(a)

4   3   2 1

|← 15mm →|

4mm

5mm

2mm

3mm

| 12mm | 10mm | 5mm | 5mm | 10mm |

(b)

3mm

10mm

5c3

4mm

20mm

| 12mm | 10mm | 5mm | 5mm | 10mm |

3mm

5mm

3mm

5b6

5a7

## Fig.12

(a)

(b)

(c)

## Fig.13

# *Fig.14*

(a)

155mm

(b)

10mm  5mm 5mm  10mm

6mm
3mm
5mm

Fig.15

## INTERNATIONAL SEARCH REPORT

| | International application No. |
|---|---|
| | PCT/JP2009/070242 |

A. CLASSIFICATION OF SUBJECT MATTER
*H01L31/042*(2006.01)i

According to International Patent Classification (IPC) or to both national classification and IPC

B. FIELDS SEARCHED

Minimum documentation searched (classification system followed by classification symbols)
H01L31/042

Documentation searched other than minimum documentation to the extent that such documents are included in the fields searched
Jitsuyo Shinan Koho        1922-1996   Jitsuyo Shinan Toroku Koho   1996-2010
Kokai Jitsuyo Shinan Koho   1971-2010   Toroku Jitsuyo Shinan Koho   1994-2010

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>A | JP 2000-31519 A (Sanyo Electric Co., Ltd.),<br>28 January 2000 (28.01.2000),<br>paragraphs [0026], [0043] to [0045]; fig. 1, 3<br>(Family: none) | 1-6<br>7-8 |
| A | JP 59-5678 A (Nippon Shisetsu Kogyo Kabushiki Kaisha),<br>12 January 1984 (12.01.1984),<br>fig. 3 to 4<br>(Family: none) | 1-8 |
| A | JP 63-147375 A (Kaneka Corp.),<br>20 June 1988 (20.06.1988),<br>page 3, upper column; fig. 4<br>(Family: none) | 1-8 |

☒ Further documents are listed in the continuation of Box C.          ☐ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 01 February, 2010 (01.02.10) | 09 February, 2010 (09.02.10) |

| Name and mailing address of the ISA/ | Authorized officer |
|---|---|
| Japanese Patent Office | |
| Facsimile No. | Telephone No. |

Form PCT/ISA/210 (second sheet) (April 2007)

**INTERNATIONAL SEARCH REPORT**

International application No.

PCT/JP2009/070242

C (Continuation).   DOCUMENTS CONSIDERED TO BE RELEVANT

| Category* | Citation of document, with indication, where appropriate, of the relevant passages | Relevant to claim No. |
|---|---|---|
| A | JP 9-51111 A  (Canon Inc.),<br>18 February 1997 (18.02.1997),<br>entire text; all drawings<br>& US 6007650 A          & US 6227270 B1 | 1-8 |
| A | JP 9-181342 A (Sharp Corp.),<br>11 July 1997 (11.07.1997),<br>paragraph [0034]; fig. 6, 8<br>(Family: none) | 1-8 |
| A | JP 63-14480 A  (Sharp Corp.),<br>21 January 1988 (21.01.1988),<br>entire text; all drawings<br>(Family: none) | 1-8 |
| A | JP 2001-293783 A  (Nisshinbo Industries, Inc.),<br>23 October 2001 (23.10.2001),<br>entire text; all drawings<br>(Family: none) | 1-8 |

Form PCT/ISA/210 (continuation of second sheet) (April 2007)

**EP 2 509 111 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 11216832 A